# FASCICULE DE BREVET EUROPEEN

(11) **EP 0 420 767 B1**
(45) Date de publication et mention de la délivrance du brevet: **03.11.1993**
(21) Numéro de dépôt: 90402700.0
(22) Date de dépôt: 28.09.1990
(51) Int. Cl.: G01R 27/32

(54) **Analyseur vectoriel de réseau millimétrique et/ou submillimétrique**
Vektoranalysator für Millimeter- und/oder Submillimeternetz
Vector analyser for millimeter and/or submillimeter network

(30) Priorité: 29.09.1989 FR 8912766
(43) Date de publication de la demande: 03.04.1991
(73) Titulaire: AB MILLIMETRE, F-75005 Paris (FR)
(72) Inventeur: Goy, Philippe, F-75014 Paris (FR); Gross, Michel, F-75012 Paris (FR)
(74) Mandataire: Michelet, Alain

(56) Documents cités:
- EP-A- 0 150 410
- US-A- 3 866 118
- TOUTE L'ELECTRONIQUE (TE), no. 526, août-septembre 1987, pages 64-70, Paris, FR; "Analyseurs de réseau: une nouvelle génération d'appareils"
- CPEM DIGEST 1976, IEEE CONFERENCE ON PRECISION ELECTROMAGNETIC MEASUREMENTS, 28 juin - 1 juillet 1976, pages 40-41, IEEE, New York, US; A.L. CULLEN et al.: "A precise injection locked I.F. phase shifting technique and its application to microwave Q factor measurement"
- TOUTE L'ELECTRONIQUE, no. 501, février 1985, pages 30-37, Paris, FR; J.-C. REGHINOT: "Appareils et méthodes de hyperfréquences"

## Description

L'invention concerne un analyseur vectoriel de réseau millimétrique et/ou submillimétrique.

Les analyseurs vectoriels de réseaux mesurent la réponse en amplitude et en phase de composants et réseaux linéaires, ces derniers ayant deux terminaisons : une entrée et une sortie. Ils effectuent la comparaison entre le signal électromagnétique incident et le signal transmis, ou réfléchi, par le composant ou le réseau étudié, généralement appelé dispositif sous test. Pour exprimer les résultats de la mesure, on utilise les paramètres S qui permettent la caractérisation simple et complète des dispositifs sous test avec la variation relative d'amplitude et la rotation d'angle de phase du signal. Il y a quatre paramètres Sᵢⱼ(F), où ᵢ ( = 1 ou 2 ) représente la terminaison où le signal est recueilli, et ⱼ (= 1 ou 2 ) la terminaison où le signal est envoyé. La notation (F) exprime que ces paramètres dépendent de la fréquence F du signal. Ainsi S₁₁(F) est la réponse en réflexion mesurée à la terminaison 1, avec le signal appliqué à cette même terminaison 1, S₂₁(F) est la réponse en transmission, recueillie en sortie 2 dans les mêmes conditions d'excitation en 1 du dispositif sous test...

L' analyseur vectoriel de réseau de l'invention permet la mesure des paramètres S dans une gamme de fréquence très étendue. Il est particulièrement bien adapté pour travailler dans le domaine s'étendant d'environ quelques GHz jusqu'à 1000GHz. Compte tenu des composants existant à l'heure actuelle, il permet d'obtenir une bonne précision dans ce domaine de fréquence mais son domaine d'application n'est pas, par principe, limité en fréquence.

De manière traditionnelle, un analyseur vectoriel de réseau comporte une source, un récepteur, le réseau à analyser devant être placé entre la source et le récepteur.

Le document EP-A-0 150 410, par exemple, décrit un analyseur vectoriel de réseau. Dans son fonctionnement millimétrique, par exemple vers 100GHz, la source est une première source hyperfréquence suivie d'un générateur harmonique de rang N. Le récepteur est un récepteur hétérodyne à plusieurs étages dont la première conversion de fréquence est effectuée par un détecteur harmonique de rang N' piloté par une deuxième source hyperfréquence. L'accord, en fréquence, de la source millimétrique et du récepteur est obtenu en utilisant comme sources hyperfréquences deux synthétiseurs programmés par un bus commun rapide de telle sorte que les balayages en fréquence soient effectués en maintenant cet accord, avec des rangs harmoniques N et N' différents.

Par ailleurs, la référence de phase nécessaire au récepteur vectoriel est obtenue en prélevant une partie de la puissance millimétrique se dirigeant vers le dispositif sous test par l'intermédiaire d'un coup leur directionnel. Cette énergie est détectée par un mélangeur harmonique de la même manière que dans la branche principale de mesure. On obtient ainsi à la fois une référence de phase et, accessoirement, un contrôle de la puissance millimétrique incidente.

Ces dispositions se sont révélées complexes et coûteuses et compte tenu des composants actuellement disponibles, le domaine spectral d'application des analyseurs vectoriels de réseaux ainsi constitué est limité.

L'invention a donc pour objet un analyseur vectoriel de réseau millimétrique dont la conception permet une réalisation simple, peu coûteuse et dont le domaine de mesure peut être étendu en fréquence.

A cet effet, l'invention concerne un analyseur vectoriel de réseau millimétrique et/ou submillimétrique du type comprenant une source millimétrique et un récepteur hétérodyne millimétrique, le réseau à analyser devant être placé entre ladite source et ledit récepteur. La source millimétrique comprend une première source hyperfréquence alimentant un générateur harmonique. Le récepteur hétérodyne millimétrique comporte en tête un mélangeur harmonique millimétrique alimenté par une deuxième source hyperfréquence qui lui sert d'oscillateur local, un récepteur HF vectoriel et des moyens de visualisation des caractéristiques du réseau analysé. Selon l'invention, l'analyseur vectoriel de réseau millimétrique comporte un dispositif d'asservissement de la fréquence d'émission de la deuxième source hyperfréquence à la fréquence de la première source hyperfréquence ou inversement, et un oscillateur HF principal pilotant ce dispositif d'asservissement. L'oscillateur principal est également utilisé directement comme référence de phase pour le récepteur HF (Haute Fréquence) vectoriel. Le générateur harmonique servant de source millimétrique et le mélangeur harmonique de tête du récepteur hétérodyne millimétrique fonctionnent au même rang harmonique.

De préférence, ce rang harmonique peut être librement déterminé entre 1 et quelques dizaines.

L'invention sera décrite ci-après en détail, en référence aux dessins annexés dans lesquels:
- La figure 1 est une représentation schématique de l'analyseur vectoriel de réseau millimétrique selon l'invention.
- La figure 2 est une représentation schématique détaillée du récepteur vectoriel HF (Haute Fréquence) mis en oeuvre dans le dispositif de l'invention.
- La figure 3 est une représentation schématique détaillée de la partie hyperfréquence du dispositif de l'invention.
- La figure 4 présente un exemple de visualisation continue de la phase d'un signal dans un domaine de variation supérieur à 360° (4B) par comparaison à la représentation du même signal faite de manière traditionnelle (4A).

Le réseau à analyser 1, également appelé dispositif sous test (device under test - DUT), est placé entre la face de sortie 2 de la source millimétrique 3 et la face d'entrée 4 du récepteur hétérodyne millimétrique 5.

La source millimétrique 3 comporte une source hyperfréqence, par exemple centimétrique 6 dite -première source hyperfréquence- dont la fréquence F₁ est multipliée par le générateur harmonique 7 de rang N, de manière à fournir l'onde millimétrique souhaitée, de fréquence Fₘₘ = NF₁. La variation de la fréquence d'émission F₁ de la source 6 par des moyens décrits en détail plus loin, ainsi que l'utilisation de divers rangs harmoniques N, permettent de produire le balayage de la fréquence d'émission de la source millimétrique 3 dans le domaine d'étude du réseau 1.

On entend ici par fréquences millimétriques des fréquences supérieures à 20GHz, par fréquences centimétriques des fréquences comprises entre 1 et 20GHz et par HF (Haute Fréquence) des fréquences comprises entre 1 et 500MHz.

Le récepteur millimétrique 5 comporte un mélangeur harmonique 8 et un récepteur vectoriel 9 accordable dans le domaine HF.

Le mélangeur harmonique 8 a comme oscillateur local une deuxième source hyperfréquence, par exemple centimétrique 10, dite -deuxième source hyperfréquence-. La fréquence d'émission F₂ de cette deuxième source hyperfréquence 10 est asservie par le dispositif d'asservissement 11 par rapport à la fréquence d'émission F₁ de la première source 6. La différence des fréquences |F₂-F₁| est maintenue constante et égale à f, de l'ordre de quelques MHz.

Le dispositif d'asservissement 11 comporte une diode mélangeuse 12 alimentée par une partie des flux émis respectivement par les sources 6 et 10 et produisant un signal fonction de la différence de leur fréquence. Après amplification par l'amplificateur 13, ce signal alimente un comparateur 14 dont la deuxième entrée est alimentée, après division de fréquence, de préférence par seize, par le diviseur 16, par l'oscillateur de référence HF 15 dit oscillateur principal. Par verrouilllage de phase, produit par le dispositif d'asservissement 11, le signal à la différence des fréquences |F₂ - F₁| = f est ainsi lié en fréquence et en phase à l'oscillateur principal HF 15.

Après conversion de l'onde millimétrique dans le mélangeur harmonique 8 placé en tête du récepteur hétérodyne 5 , le récepteur vectoriel HF 9 est alimenté en 9ₐ par des signaux aux fréquences intermédiaires F_{if} = |Fₘₘ - N'F₂| où N' est le rang harmonique du mélangeur harmonique 8. Dans les conditions N' = N et f = |F₂ - F₁|, le récepteur vectoriel sélectif HF 9 choisira, parmi les fréquences fixes F_{if} = Nf, celle de l'harmonique N retenu.

On utilise comme sources hyperfréquences 6, 10, des oscillateurs à transistors à effet de champ, de même type, accordables électriquement (par exemple de 8 à 18GHz) par la résonance d'une cavité à grenat d'yttrium-fer (Yig). Le mélangeur harmonique 8 fonctionne au même rang harmonique N que le générateur harmonique 7. Les générateur 7 et mélangeur 8 harmoniques sont avantageusement des dispositifs à diodes Schottky.

Le dispositif d'asservissement 11, fonctionnant entièrement dans les gammes HF et ondes centimétriques, permet donc de réaliser avec des composants connus et relativement peu coûteux l'adaptation du récepteur millimétrique 5 à la fréquence d'émission de la source millimétrique 3 avec le mélangeur harmonique 8 fonctionnant au même rang harmonique N que le multiplicateur 7.

L'oscillateur principal 15 servant également de référence pour le récepteur vectoriel HF accordable 9, la cohérence de phase est conservée.

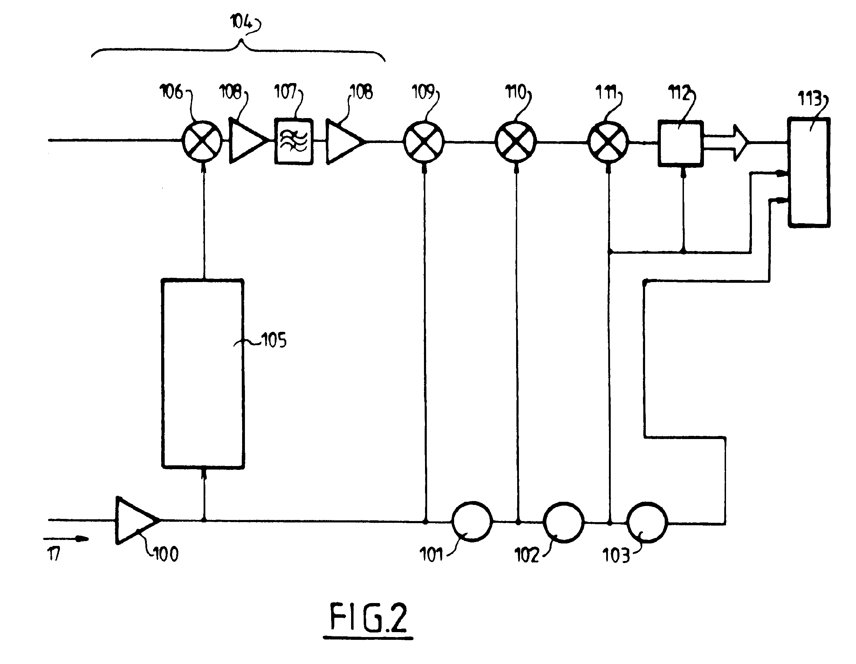

Le récepteur vectoriel 9 est représenté sur la figure 2. Il comporte plusieurs changements de fréquence, chacun réalisé à l'aide d'un oscillateur local référencé en phase. Ces références sont obtenues par une cascade de diviseurs partant de la référence fournie par l'oscillateur 15.

L'oscillateur principal 15 fournit un signal de référence, de préférence à 50MHz. Sa fréquence est divisée par le diviseur 17, de préférence par cinq. La référence à 10 MHz est amplifiée par l'amplificateur 100, le diviseur 101 fournit une référence à 1MHz, le diviseur 102 une référence à 10kHz et enfin le diviseur 103 une référence à 250Hz. Toutes ces références sont calées en phase sur le signal à 50MHz émis par l'oscillateur principal 15.

Les valeurs numériques sont données à titre d'exemple. Toutefois, celles qui sont indiquées présentent l'avantage d'éviter tout brouillage par coïncidence harmonique entre la fréquence f = 3,125 MHz et les autres références à 50 MHz et 10 MHz venant de l'oscillateur principal HF 15.

Comme nous l'avons vu plus haut, le récepteur vectoriel HF 9 reçoit un signal à une fréquence f, par exemple 3,125MHz ou l'un de ses harmoniques Nf.

Le premier étage de conversion 104 comporte un synthétiseur 105 fonctionnant entre 0 et 300MHz, qui prend sa référence 10MHz sur le signal issu de l'oscillateur principal 15. Le synthétiseur 105 est capable de fournir les fréquences Nf+ f' (de préférence f'= +/- 9,01025MHz) avec la puissance nécessaire (15mW par exemple). Ce premier étage 104 comporte également un mélangeur passif 106 alimenté d'une part par le signal de mesure à la fréquence Nf, d'autre part par le signal fourni par le synthétiseur 105. Ce mélangeur 106 produit donc un signal de battement sur sa sortie à une fréquence constante de 9,01025MHz, porteur des informations de phase et d'amplitude du signal de mesure. A la sortie du mélangeur 106, le signal est amplifié par un amplificateur 108 suivi d'un filtre 107 à la fréquence 9,01025MHz, qui élimine les parasites de ce signal. Enfin, un deuxième amplificateur 108' est appliqué au signal filtré.

Les étages suivants comportent chacun un mélangeur, respectivement 109, 110, 111, dont la voie oscillateur local est alimentée par un signal à respectivement 10MHz, 1MHz et 10kHz, obtenu par divisions successive de la fréquence du signal fourni par l'oscillateur principal 15. Le mélangeur 109, dont l'oscillateur local est à 10MHz, produit à sa sortie un signal à 989,75kHz; le mélangeur 110, dont l'oscillateur local est à 1MHz fournit un signal à sa sortie à 10,25kHz; le mélangeur 111, dont l'oscillateur local est à 10kHz, fournit à sa sortie un signal à la fréquence de 250Hz. Les mélangeurs 109, 110, 111 sont des mélangeurs actifs, où la perte de conversion de la fonction mélangeur est compensée par un amplificateur incorporé.

A la sortie du mélangeur 111, aprés la dernière conversion de fréquence à 250 Hz, un convertisseur analogique numérique 112 numérise le signal de mesure par échantillonnage à une fréquence de 10kHz. L'horloge d'échantillonnage est obtenue par division du signal 10MHz émis par l'oscillateur principal 15. Le signal ainsi numérisé alimente un ordinateur qui est programmé de manière à exploiter ce signal de fréquence 250Hz conjointement avec l'horloge d'échantillonnage à 10kHz et avec un signal de référence à 250Hz également produit par division de fréquence à partir de l'oscillateur 10MHz principal HF 15, de manière à extraire, mémoriser et visualiser les informations d'amplitude et de phase du signal de mesure. Cet ordinateur 113 est susceptible de fournir tout type de représentation de l'amplitude et de la phase du signal de mesure en fonction de la fréquence d'émission de la source 3. Il visualise les caractéristiques du réseau analysé.

Le premier mode de réalisation possible est la représentation polaire de l'amplitude et de la phase, où l'amplitude est la distance au centre et la phase l'angle que fait la direction du point considéré avec un axe d'origine.

Ce type de représentation polaire à deux dimensions rend difficile la représentation de ces paramètres en fonction d'une troisième variable, telle que la fréquence, par exemple. C'est la raison pour laquelle on représente le plus souvent indépendamment les variations de phase et celles d'amplitude, en fonction de la fréquence, ou du temps, ou de l'angle de pointé d'une antenne, etc dans un système cartésien.

Dans ce cas, la représentation de la phase en coordonnées cartésiennes est limitée à une amplitude de 360°, généralement le diagramme est limité entre -180° et +180°. Dans le cas des analyseurs de réseau millimétrique, il est fréquent que la variation continue de la phase dépasse 360°. Dans ce cas, la représentation cartésienne présente l'aspect d'une courbe en dents de scie (figure 4A) avec des discontinuités apparentes quand la phase atteint les valeurs de plus ou moins 180°. Ces discontinuités, qui ne correspondent à aucune réalité physique, sont gênantes.

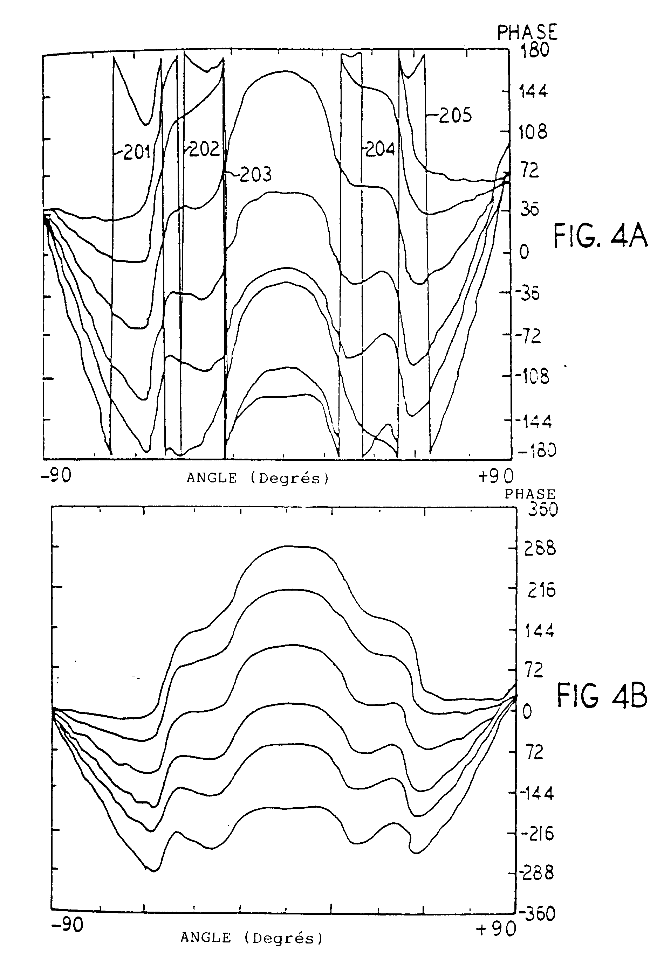

Afin d'illustrer la représentation du signal de mesure, la figure 4 présente le résultat d'un test dans lequel le composant étudié est une antenne. Dans ce cas l'antenne à tester est placée sur un pivot tournant en regard d'une antenne émettrice positionnée à une distance suffisante pour que l'onde incidente puisse être considérée, au niveau de l'antenne testée, comme plane. La figure 4 représente le retard de la phase du signal reçu en fonction de la direction de pointé de l'antenne réceptrice par rapport à la direction de l'antenne émettrice pour des éloignements variés de l'embouchure de l'antenne testée par rapport à l'axe de rotation.

Un mode de réalisation particulièrement avantageux dans le cadre de l'étude des réseaux vectoriels millimétriques consiste à supprimer toute discontinuité non physique de la phase dans sa représentation cartésienne. A cet effet, l'ordinateur 113 extrait du signal fourni en temps réel par le convertisseur analogique numérique 112, l'amplitude A et la phase u. La phase comprise entre -180° et +180° est mise en mémoire. A la relecture, l'ordinateur est programmé de manière à reconnaître par une étude de la pente de la phase les discontinuités brutales telles que référencées 201 à 205 sur la figure 4A. Ces discontinuités étant alors considérées comme le produit de la représentation et non d'un phénomène physique, il est rajouté 360° à leur borne inférieure. L'ordinateur adapte alors l'échelle de manière à permettre une représentation complète du signal telle que représentée sur la figure 4B. Ce type de représentation est appelé représentation continue de la phase.

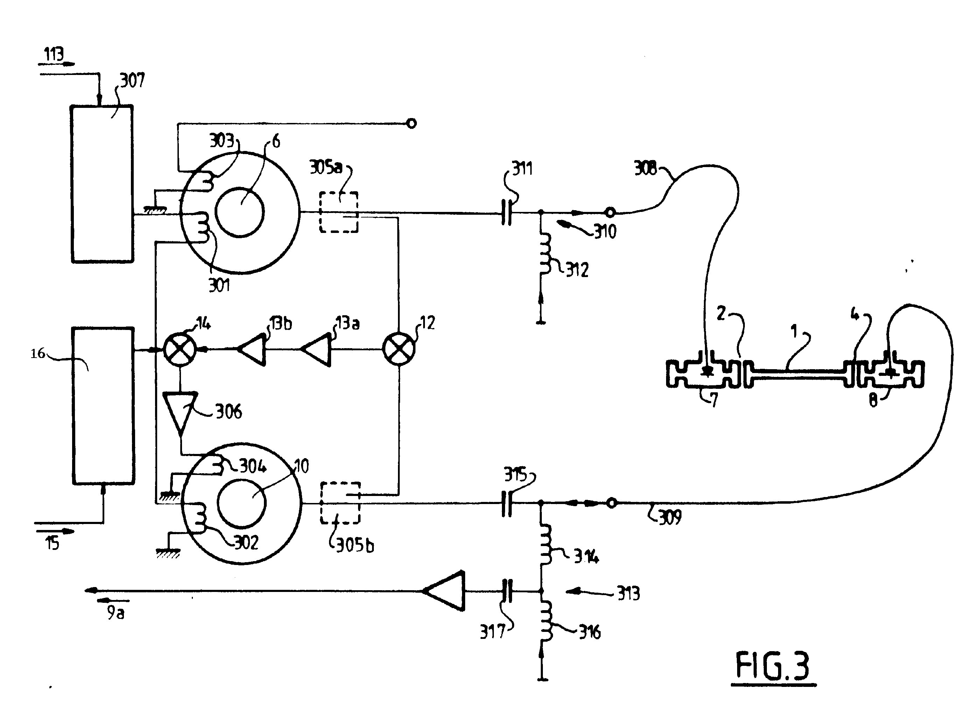

Nous décrirons maintenant plus en détail les sources et leurs liaisons en référence à la figure 3.

Les première et deuxième sources hyperfréquences 6 et 10 sont des transistors à effet de champ suivi d'étages d'amplification-isolement. Elles sont largement balayables grâce à un pilotage par cavité résonnante à cristaux de grenat d'yttrium-fer (dit Yig) de 8 à 18GHz. Elles fournissent une puissance de sortie de l'ordre de 100 milliwatts avec un spectre de puissance centimétrique présentant une largeur à mi-hauteur de l'ordre de 10kHz. Les cavités à Yig présentent une résonance ferro-magnétique. Elles sont soumises au champ magnétique créé par deux types d'enroulements, l'enroulement principal (respectivement 301, 302) assure le positionnement grossier de la fréquence de chaque source 6, 10. Les enroulements secondaires respectivement 303, 304 permettent d'effectuer rapidement des corrections de fréquence de faible amplitude (jusqu'à 100MHz). Les enroulements principaux 301, 302 sont montés en série de manière à éviter tout décalage relatif pouvant être dû à une fluctuation de l'alimentation en courant. Ils sont alimentés par une alimentation 307 régulée et réglable.

Le mélangeur 12 du dispositif d'asservissement 11 est une diode Schottky susceptible de fonctionner entre 0,1 MHz et 18GHz. Elle est alimentée d'une part par une partie du flux émis par la source 6 prélevée par un coupleur directionnel 305a et d'autre part par une partie du flux émis par la source 10 prélevée par un coupleur directionnel 305b. Ces coupleurs sont choisis de telle sorte que le niveau du signal prélevé sur le flux émis par l'une des sources soit de niveau plus fort (environ 10 mW) que celui prélevé sur le flux émis par l'autre, de telle sorte que le flux le plus intense serve d'oscillateur local à la diode Schottky 12 fonctionnant comme mélangeur.

La diode 12 fournit un signal de battement dont la fréquence est comprise entre zéro et 60MHz environ. Un premier amplificateur 13a élève une première fois le niveau du signal et l'envoie sur un amplificateur à saturation 13b de manière à ce qu'il attaque le comparateur fréquence/phase 14 avec un niveau constant. L'autre branche de ce comparateur 14 est alimentée par un signal de référence, à fréquence f par exemple à 3,125MHz, produit par division,par le diviseur de fréquence 16 à partir du signal émis par l'oscillateur HF principal 15. La tension de correction engendrée par le comparateur 14 est amplifiée par l'amplificateur 306 et envoyée au bobinage secondaire 304 de la source 10 dont la fréquence est ainsi asservie à celle de la source 6.

Le bobinage secondaire 303 de la source 6 peut avantageusement être utilisé pour effectuer la stabilisation extérieure de cette source. Toutefois, il est à souligner que cette stabilisation n'est pas indispensable. Lors de la modification du rang harmonique de travail du multiplicateur 7 et donc également du mélangeur harmonique 8, l'accord du récepteur HF est modifié ce qui permet d'éviter la modification de la différence des fréquences d'émission des sources 6 et 10.

Le générateur harmonique 7 et le mélangeur harmonique 8 sont respectivement reliés aux sources hyperfréquences 6 et 10 par des câbles coaxiaux souples 308 et 309. Le câble 308 comporte à son extrémité opposée au générateur harmonique 7 un té de polarisation 310 composé d'une inductance 312 et d'un condensateur 311 qui lui permettent de combiner le signal émis par la source hyperfréquence 6 et le courant continu de polarisation du générateur harmonique 7. Le câble 309 comporte à son extrémité opposée au mélangeur harmonique 8 un double té 313 ,composé d'un premier ensemble, inductance-condensateur 314, 315 suivi d'un deuxième ensemble de même nature 316, 317. Ce double té 313 permet au câble 309 de véhiculer, simultanément, le signal HF recueilli au mélangeur harmonique 8, le courant continu de polarisation de ce mélangeur, et le signal émis par la deuxième source hyperfréquence 10 en direction de ce même mélangeur harmonique.

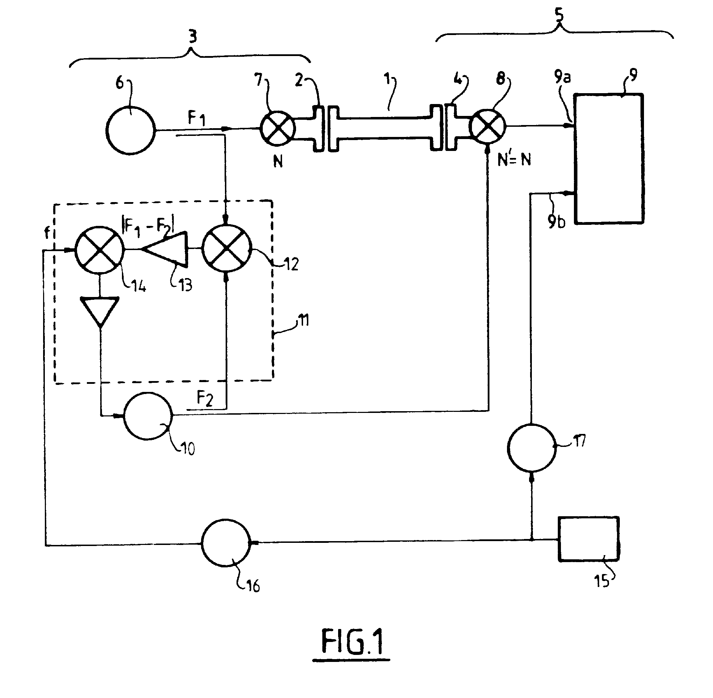

La disposition montrée en figures 1 ou 3 permet la mesure du paramètre S₂₁, qui correspond au fonctionnement du réseau millimétrique étudié par transmission. L'utilisation d'un coupleur directionnel puis l'inversion des fonctions respectives de la source et du récepteur permettent de manière traditionnelle d'accéder de manière analogue aux autres paramètres Sᵢⱼ.

Le dispositif de l'invention permet l'analyse vectorielle de réseau hyperfréquence en couvrant pleinement le domaine millimétrique. Les moyens qu'il requiert sont légers et efficaces et en particulier il ne nécessite pas la synthèse de fréquence-hyperfréquence ni de coupleur directionnel de contrôle de l'onde incidente. Les sources et détecteurs mis en oeuvre sont maniables et légers. Comme nous l'avons vu, la phase de référence est obtenue directement au niveau du signal HF ce qui simplifie l'appareil et permet d'atteindre de très hautes fréquences de fonctionnement.

Par ailleurs la dynamique disponible est importante. Avec les composants actuellement disponibles la dynamique dépasse 80dB à 100GHz et atteint 50dB à 300GHz, avec un bruit de phase inférieur à 0,2° et 1° respectivement.

Les moyens décrits ci-desssus permettent de couvrir complètement le domaine millimétrique et le début du domaine submillimétrique, par exemple jusqu'à 450GHz. On peut étendre le domaine submillimétrique de mesure en choisissant des sources millimétriques à la place des sources hyperfréquences ou à la place de l'une d'entre-elles. Par exemple on peut utiliser un oscillateur à diode Gunn stabilisé en fréquence sur l'harmonique 7 de la source hyperfréquence 6 et suivi par un générateur d'harmoniques 3 à 10. Cela permet de travailler jusqu'à 1000GHz avec le récepteur millimétrique accordé sur les harmoniques 21 à 70. L'appareil reste alors conforme à l'invention, en particulier l'oscillateur principal HF est directement utilisé comme référence de phase.

## Revendications

1. Analyseur vectoriel de réseau millimétrique et/ou submillimétrique comprenant:
. une source millimétrique (3) et un récepteur hétérodyne millimétrique (5), le réseau (1) à analyser devant être placé entre ladite source (3) et ledit récepteur (5),
. la source millimétrique (3) comprenant une première source hyperfréquence (6) alimentant un générateur harmonique millimétrique (7),
. le récepteur hétérodyne millimétrique (5) comportant en tête un mélangeur harmonique millimétrique alimenté par une deuxième source hyperfréquence (10) qui lui sert d'oscillateur local, un récepteur HF vectoriel (9) et des moyens de visualisation des caractéristiques du réseau analysé,
caractérisé en ce que
. il comporte un dispositif d'asservissement (11) de la fréquence d'émission de la deuxième source hyperfréquence (10) à la fréquence de la première source hyperfréquence (6) ou inversement, et un oscillateur HF principal (15) pilotant ce dispositif d'asservissement (11),
. ledit oscillateur principal (15) étant également utilisé, directement, comme référence de phase pour le récepteur HF vectoriel (9),
. le générateur harmonique millimétrique (7) alimenté par la première source hyperfréquence (6) et le mélangeur harmonique millimétrique (8) du récepteur hétérodyne millimétrique (5) fonctionnant au même rang harmonique.

2. Analyseur vectoriel de réseau millimétrique selon la revendication 1 caractérisé en ce que le rang harmonique commun aux générateur (7) et mélangeur (8) harmoniques millimétriques peut être librement déterminé entre 1 et quelques dizaines.

3. Analyseur vectoriel de réseau millimétrique selon l'une des revendications 1 et 2, caractérisé en ce que la première et la deuxième source hyperfréquence (6, 10) comportent des oscillateurs à transistor à effet de champ, chacun piloté par résonance dans une cavité à grenat d'yttrium-fer, nommée cavité à à Yig.

4. Analyseur vectoriel de réseau millimétrique selon l'une des revendications 2 et 3, caractérisé en ce que le récepteur HF vectoriel (9) est accordable.

5. Analyseur vectoriel de réseau millimétrique selon l'une quelconque des revendications 1 à 4, caractérisé en ce que le récepteur HF vectoriel (9) comporte plusieurs étages de conversion dudit signal de battement, de manière à en diminuer la fréquence tout en conservant les informations d'amplitude et de phase, chacun d'eux comportant un oscillateur HF local lié en phase à l'oscillateur HF principal (15).

6. Analyseur vectoriel de réseau millimétrique selon la revendication 5, caractérisé en ce que l'oscillateur HF local du premier étage de conversion est un synthétiseur HF programmable.

7. Analyseur vectoriel de réseau millimétrique selon la revendication 6, caractérisé en ce que les oscillateurs HF locaux des étages de conversions suivant le premier sont obtenus par division de la fréquence de l'oscillateur HF principal (15).

8. Analyseur vectoriel de réseau millimétrique selon l'une quelconque des revendications 4 à 7, caractérisé en ce qu'il comporte un échantillonneur analogique/numérique (112) numérisant le signal fourni par le dernier étage de conversion et un ordinateur (113) alimenté par le signal de mesure sortant de l'échantillonneur (112) et par un signal de référence produit par division de fréquence à partir de l'oscillateur HF principal (15), le dit ordinateur (113) étant programmé de manière à extraire, mémoriser et visualiser les informations d'amplitude et de phase du signal de mesure.

9. Analyseur vectoriel de réseau millimétrique selon la revendication 8, caractérisé en ce que l'ordinateur (113) réalise , en différé, une visualisation continue de la phase même lorsque son domaine de variation est supérieur à 360°.

10. Analyseur vectoriel de réseau millimétrique selon l'une quelconque des revendications 1 à 9, caractérisé en ce que les cavités à Yig de chaque source hyperfréquence (6, 10) comportent un bobinage principal (301, 302) et un bobinage secondaire (303, 304) controlant leurs fréquences respectives, et que le dispositif d'asservissement (11) de la fréquence d'émission de la deuxième source hyperfréquence (10), à Yig, à la fréquence de la première source hyperfréquence (6), à Yig, comporte un premier coupleur (305a) permettant de prélever une partie du flux émis par la première source (6) hyperfréquence, un deuxième coupleur (305b) permettant de prélever une partie du flux émis par la deuxième source hyperfréquence (10), un mélangeur (12) produisant un signal de battement des flux prélevés, alimentant un comparateur de phase (14) qui contrôle la fréquence de la deuxième source hyperfréquence (10) par le bobinage secondaire (304) de contrôle de sa cavité à Yig, le bobinage principal (302) étant en série avec celui (301) de la première source hyperfréquence.

## Patentansprüche

1. Vektoranalysator für ein Millimeter- und/oder Submillimeternetz mit:
- einer Millimeter-Quelle (3) und einem Millimeter-Heterodynempfänger (5), wobei das zu analysierende Netz (1) zwischen der Quelle (3) und dem Empfänger (5) angeordnet sein muß,
- wobei die Millimeter-Quelle (3) eine erste Ultrahochfrequenzquelle (6) aufweist, die einen Millimeter-Oberwellengenerator (7) versorgt,
- wobei der Millimeter-Heterodynempfänger (5) am Kopf eine Millimeter-Oberwellenmischvorrichtung, die von einer zweiten Ultrahochfrequenzquelle (10) versorgt wird, welche dieser als lokaler Oszillator dient, einen vektoriellen HF-Empfänger (9) und Einrichtungen zur Sichtbarmachung der Eigenschaften des analysierten Netzes aufweist,
dadurch gekennzeichnet, daß
- er eine Vorrichtung (11) zum Regeln der Sendefrequenz der zweiten Ultrahochfrequenzquelle (10) auf die Frequenz der ersten Ultrahochfrequenzquelle (6), oder umgekehrt, und einen Haupt- HF-Oszillator (15) aufweist, der die Regelvorrichtung (11) steuert,
- wobei der Hauptoszillator (15) auch direkt als Phasenreferenz für den vektoriellen HF-Empfänger (9) verwendet wird,
- wobei der von der ersten Ultrahochfrequenzquelle (6) versorgte Millimeter-Oberwellengenerator (7) und die Millimeter-Oberwellenmischvorrichtung (8) des Millimeter-Heterodynempfängers (5) in der gleichen Oberwellenordnung arbeiten.

2. Vektoranalysator für ein Millimeternetz nach Anspruch 1, dadurch gekennzeichnet, daß die dem Millimeter-Oberwellengenerator (7) und der -mischvorrichtung (8) gemeinsame Oberwellenordnung frei zwischen 1 und einigen Zehn wählbar ist.

3. Vektoranalysator für ein Millimeternetz nach den Ansprüchen 1 und 2, dadurch gekennzeichnet, daß die erste und die zweite Ultrahochfrequenzquelle (6, 10) Feldeffekttransistor-Oszillatoren aufweisen, die in einem Yttrium-Eisen-Granat-Hohlraum, der auch als Yig-Hohlraum bezeichnet wird, jeweils resonanzgesteuert sind.

4. Vektoranalysator für ein Millimeternetz nach den Ansprüchen 2 und 3, dadurch gekennzeichnet, daß der vektorielle HF-Empfänger (9) abstimmbar ist.

5. Vektoranalysator für ein Millimeternetz nach einem der Ansprüche 1 bis 4, dadurch gekennzeichnet, daß der vektorielle HF-Empfänger (9) mehrere Stufen zum Umwandeln des Überlagerungssignals aufweist, derart, daß die Frequenz verringert, die Amplituden- und Phaseninformationen jedoch erhalten bleiben, wobei jede der Stufen einen lokalen HF-Oszillator aufweist, der mit dem Haupt- HF-Oszillator (15) phasengekoppelt ist.

6. Vektoranalysator für ein Millimeternetz nach Anspruch 5, dadurch gekennzeichnet, daß der lokale HF-Oszillator der ersten Wandlerstufe eine programmierbare HF-Synthetisierungseinrichtung ist.

7. Vektoranalysator für ein Millimeternetz nach Anspruch 6, dadurch gekennzeichnet, daß die lokalen HF-Oszillatoren der der ersten Stufe folgenden Wandlerstufen durch Teilung der Frequenz des Haupt- HF-Oszillators (15) erhalten werden.

8. Vektoranalysator für ein Millimeternetz nach einem der Ansprüche 4 bis 7, dadurch gekennzeichnet, daß er eine Analog-/Digital-Abfrageeinrichtung (112), die das von der letzten Wandlerstufe gelieferte Signal digitalisiert, und einen Rechner (113) aufweist, dem das Meßsignal der Abfrageeinrichtung (112) und ein Referenzsignal zugeführt wird, das von dem Haupt- HF-Oszillator (15) durch Frequenzteilung erzeugt wird, wobei der Rechner (113) derart programmiert ist, daß er die Amplituden- und Phaseninformationen des Meßsignals extrahiert, speichert und darstellt.

9. Vektoranalysator für ein Millimeternetz nach Anspruch 8, dadurch gekennzeichnet, daß der Rechner (113) zwischengespeichert eine fortgesetzte Darstellung der Phase durchführt, selbst wenn die Variationsbreite größer als 360° ist.

10. Vektoranalysator für ein Millimeternetz nach einem der Ansprüche 1 bis 9, dadurch gekennzeichnet, daß der Yig-Hohlraum jeder Ultrahochfrequenzquelle (6, 10) eine Primärwicklung (301, 302) und eine Sekundärwicklung (303, 304) aufweist, die deren jeweilige Frequenzen steuern, und daß die Vorrichtung (11) zum Regeln der Sendefrequenz der zweiten Yig-Ultrahochfrequenzquelle (10) auf die Frequenz der ersten Yig-Ultrahochfrequenzquelle (6) einen ersten Koppler (305a), der das Entnehmen eines Teils des von der ersten Ultrahochfrequenzquelle (6) emittierten Flusses ermöglicht, einen zweiten Koppler (305b), der das Entnehmen eines Teils des von der zweiten Ultrahochfrequenzquelle (10) emittierten Flusses ermöglicht, und eine Mischeinrichtung (12) aufweist, die ein Überlagerungssignal der entnommenen Flüsse erzeugt, das einen Phasenkomparator (14) versorgt, der die Frequenz der zweiten Ultrahochfrequenzquelle (10) über die Steuer-Sekundärwicklung (304) ihres Yig-Hohlraums steuert, wobei die Primärwicklung (302) mit derjenigen (301) der ersten Ultrahochfrequenzquelle in Reihe geschaltet ist.

## Claims

1. Millimetre and/or submillimetre network vector analyzer comprising
a millimetre source (3) and a millimetre heterodyne receiver (5), the network (1) to be analyzed requiring to be placed between the said source (3) and the said receiver (5),
the millimetre source (3) comprising a first microwave source (6) feeding a millimetre harmonic generator (7),
the millimetre heterodyne receiver (5) comprising firstly a millimetre harmonic mixer fed by a second microwave source (10) which serves as a local oscillator for it, an HF vector receiver (9) and means for displaying the characteristics of the analyzed network,
characterized in that
it comprises a device for servocontroller (11) the emission frequency of the second microwave source (10) by the frequency of the first microwave source (6) or conversely, and a main HF oscillator (15) activating this servocontroller device (11),
the said main oscillator (15) also being directly used as phase reference for the HF vector receiver (9),
the millimetre harmonic generator (7) fed by the first microwave source (6) and the millimetre harmonic mixer (8) of the millimetre heterodyne receiver (5) operating at the same harmonic order.

2. Millimetre network vector analyzer according to Claim 1, characterized in that the harmonic order common to the millimetre harmonic generator (7) and mixer (8) may be freely specified between 1 and a few tens.

3. Millimetre network vector analyzer according to one of Claims 1 and 2, characterized in that the first and the second microwave source (6,10) comprise field-effect transistor oscillators, each activated by resonance in a garnet yttrium-iron cavity called Yig cavity.

4. Millimetre network vector analyzer according to one of Claims 2 and 3, characterized in that the HF vector receiver (9) is tunable.

5. Millimetre network vector analyzer according to any one of Claims 1 to 4, characterized in that the HF vector receiver (9) comprises several stages for converting the said beat signal, in such a way as to decrease the frequency whilst conserving the amplitude and phase information, each of them comprising a local HF oscillator phase-tied to the main HF oscillator (15).

6. Millimetre network vector analyzer according to Claim 5, characterized in that the local HF oscillator of the first conversion stage is a programmable HF synthesizer.

7. Millimetre network vector analyzer according to Claim 6, characterized in that the local HF oscillators of the conversion stages following the first one are obtained by dividing the frequency of the main HF oscillator (15).

8. Millimetre network vector analyzer according to any one of Claims 4 to 7, characterized in that it comprises an analog/digital sampler (112) digitizing the signal supplied by the final conversion stage and a computer (113) fed by the measurement signal leaving the sampler (112) and by a reference signal produced by frequency division from the main HF oscillator (15), the said computer (113) being programmed in such a way as to extract, store and display the amplitude and phase information from the measurement signal.

9. Millimetre network vector analyzer according to Claim 8, characterized in that the computer (113) carries out a deferred, continuous display of the phase even when its field of variation is greater than 360°.

10. Millimetre network vector analyzer according to any one of Claims 1 to 9, characterized in that the Yig cavities of each microwave source (6,10) comprise a main coil (301,302) and a secondary coil (303,304) controlling their respective frequencies, and that the device for servocontrolling (11) the emission frequency of the second Yig microwave source (10) by the frequency of the first Yig microwave source (6) comprises a first coupler (305a) enabling sampling of part of the flux emitted by the first microwave source (6), a second coupler (305b) enabling sampling of part of the flux emitted by the second microwave source (10), a mixer (12) producing a beat signal from the sampled fluxes, feeding a phase comparator (14) which controls the frequency of the second microwave source (10) via the secondary coil (304) for controlling its Yig cavity, the main coil (302) being in series with that (301) of the first microwave source.
